(19) Europäisches Patentamt
European Patent Office
Office européen des brevets

(11) **EP 2 924 448 B1**

(12) **EUROPEAN PATENT SPECIFICATION**

(45) Date of publication and mention
of the grant of the patent:
**20.11.2019   Bulletin 2019/47**

(21) Application number: **13856145.1**

(22) Date of filing: **15.08.2013**

(51) Int Cl.:
*G01R 11/00* [(2006.01)]     *G01R 11/02* [(2006.01)]
*G01R 1/20* [(2006.01)]       *G01R 22/08* [(2006.01)]
*G01R 22/06* [(2006.01)]      *H01C 3/02* [(2006.01)]

(86) International application number:
**PCT/CN2013/081567**

(87) International publication number:
**WO 2014/079238 (30.05.2014 Gazette 2014/22)**

(54) **ELECTRONIC ELECTRIC METER RESISTANT TO ALTERNATING MAGNETIC FIELD INTERFERENCES**

ELEKTRONISCHER STROMZÄHLER IMMUN GEGEN INTERFERENZEN DURCH MAGNETISCHE WECHSELFELDER

COMPTEUR ÉLECTRIQUE ÉLECTRONIQUE RÉSISTANT AUX INTERFÉRENCES DE CHAMP MAGNÉTIQUE ALTERNATIF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:   **26.11.2012   CN 201220633691 U**

(43) Date of publication of application:
**30.09.2015   Bulletin 2015/40**

(73) Proprietor: **Xiamen Hongfa Electric Power Controls Co., Ltd.**
**Fujian 361021 (CN)**

(72) Inventors:
• **HONG, Yaosheng**
**Xiamen, Fujian 361021 (CN)**

• **ZHONG, Shuming**
**Xiamen, Fujian 361021 (CN)**
• **LEE, Lianyong**
**Xiamen, Fujian 361021 (CN)**

(74) Representative: **Potter Clarkson**
**The Belgrave Centre**
**Talbot Street**
**Nottingham NG1 5GG (GB)**

(56) References cited:
**CN-A- 102 323 459        CN-A- 102 707 115**
**CN-U- 202 177 647        CN-U- 202 903 841**
**CN-Y- 2 599 592          CN-Y- 200 976 020**
**CN-Y- 201 429 643        FR-A1- 2 884 615**
**US-A- 4 494 068          US-A1- 2004 263 150**
**US-A1- 2008 239 574**

## Description

### TECHNICAL FIELD

The invention relates to an electronic device, and more particularly, an electronic electric meter which can reduce the alternating magnetic field interferences to a current divider (shunt) acting as a current sampling element.

### BACKGROUND

The electronic electric meter is an electronic device, which takes real-time sampling to the supply voltages and currents of customers and uses dedicated integrated circuit of electric meter, so as to process and convert signals of the sampled voltages and currents into a pulse output being proportional to the electric energy by multiplying the signals, and then display the output by means of a register or a digital indicator. For example, US4494068A discloses a measurement shunt comprises a resistance provided with first and second voltage terminals and intended to provide a voltage representative of an electric current passing through it, and an inductance connected to at least the first of said voltage terminals to produce between first and second measurement terminals a voltage free of error voltages induced in said resistance, even if the presence of a variable magnetic field. CN201429643Y discloses a novel diverter which adopts an integrated structure and is formed and molded by the panel of resistance material. The two ends of the diverter are provided with two connecting fixing devices. The middle of the diverter is provided with a hole. A sampling resistance is the part between the upper edge extension line and the lower edge extension line of the hole. A sampling point is positioned between the two edge lines. The sampling point position can be provided with a fixing hole and a current signal wire is fixed by a bolt or the hole is not needed, the current signal wire is fixed in the welding or pressing way. CN202177647U provides an alternating magnetic field resistant manganin diverter, mainly comprising a manganin resistor body and sampling endpoints of the diverter, wherein one side of the diverter is provided with a conductor, both sides of the diverter are respectively provided with one sampling endpoint, the sampling endpoints are connected with sampling lines, the sampling line at one side of the diverter extends to the other side to divide the manganin resistor body into two portions with the same area, and is fixed with the sampling line at the other side, and then the sampling lines are spirally intertwisted, and extend. The alternating magnetic field resistant maganin diverter enables the sampling line near one side of the manganin resistor to extend near the other side of the manganin resistor, the manganin resistor is averagely divided into two portions with the same area, such that according to the Faraday electromagnetic induction law, when the diverter is influenced by the external alternating magnetic field, an induction voltage and an electromotive force are generated on the sampling line extending near the other side of the manganin resistor, and are balanced with the induction voltage and the electromotive force generated on the manganin resistor, thereby preventing the alternating magnetic field from generating influence on the diverter.

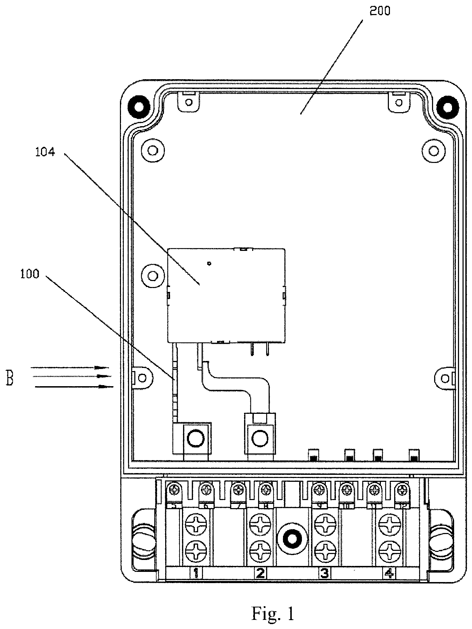

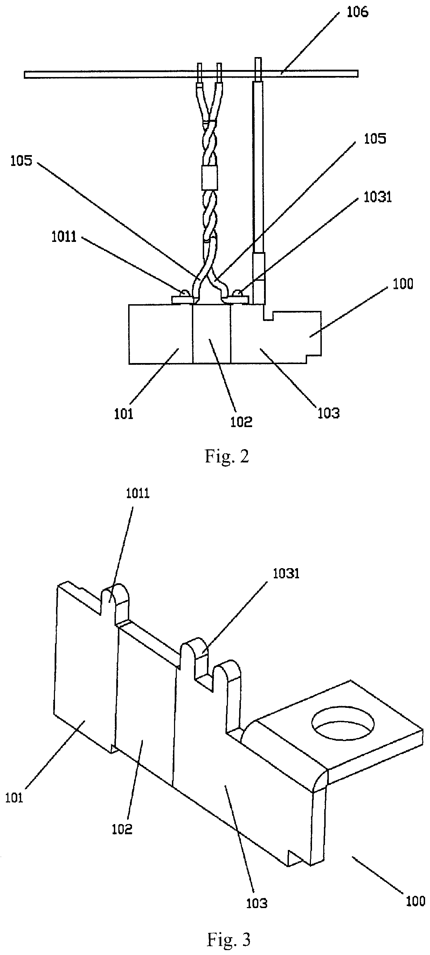

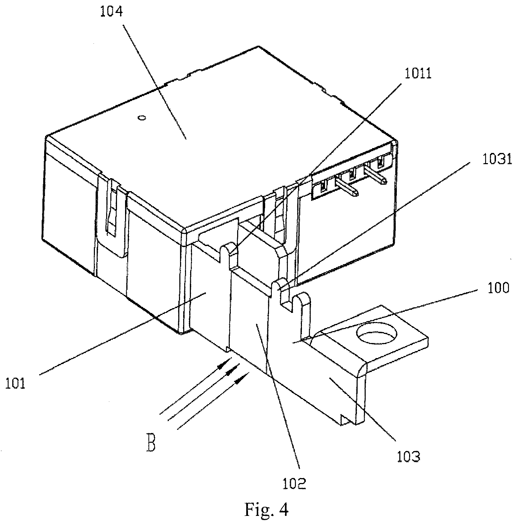

In an electronic electric meter in prior art, high stability materials such as manganin are used to produce the current sampling element. Fig. 1 is a schematic diagram showing the configuration of an electronic electric meter in prior art, Fig. 2 is a schematic diagram showing the structure of a current sampling circuit of an electronic electric meter in prior art, Fig. 3 is a schematic diagram showing the structure of a manganin current divider of an electronic electric meter in prior art, and Fig. 4 is a schematic diagram showing the installation of a manganin current divider of an electronic electric meter in prior art. Referring to Fig. 1, a manganin current divider 100 and a relay 104 are mounted within a housing 200 of an electronic electric meter. The electronic electric meter is connected to a cable, so an alternating magnetic field interference with a field direction as shown by the arrows in the Fig. 1) is generated. The relay 104 is connected to the manganin current divider 100 at one side. Referring to Figs. 2-4, the manganin current divider 100 comprises a first copper sheet portion 101, a sheet portion of manganin 102 and a second copper sheet portion 103. Both ends of the manganin portion 102 are integrally connected to the first copper sheet portion 101 and the second copper sheet portion 103, respectively. The first copper sheet portion 101, the manganin portion 102 and the second copper sheet portion 103 are all planar structures and locate in the same plane. The manganin current divider 100 is typically connected to a terminal (leading-out end) of the relay 104, i.e., the first copper sheet portion 101 of the manganin current divider 100 is connected to the terminal of the relay 104. A first connecting end 1011 close to the manganin portion 102 is provided on the first copper sheet portion 101, and a second connecting end 1031 close to the manganin portion 102 is provided on the second copper sheet portion 103. One signal line 105 is welded on each of the first connecting end 1011 and the second connecting end 1031. The ends of the two signal lines 105 are connected to a circuit board 106 of the electronic electric meter. The first connecting end 1011 and the second connecting end 1031 are both formed by protruding upwards from an upper-side edge of the manganin current divider 100, i.e., the first connecting end 1011 is formed by protruding upwards from an upper-side edge of the first copper sheet portion 101, and the second connecting end 1031 is formed by protruding upwards from an upper-side edge of the second copper sheet portion 103. The electronic electric meter with such a structure may make a mistake to measure the interferences into the electric energy as several pulses, when the outside interferences exist. Under the effect of an alternating magnetic field, the closed circuit formed by the manganin current divider 100, the signal lines 105, and the circuit board 106 of the electronic electric meter will generate an induced electromotive force and an induced current, so as to prevent the current of the circuit from varying. According to the Law of Electromagnetic

Induction: $E = -N\dfrac{d\phi}{dt}$, $\phi = B*S$, wherein $\phi$ is the

magnetic flux through the closed circuit, t is time, B is magnetic flux density, S is the area perpendicular to the field direction. Thus the accuracy of measurement of the electronic electric meter, especially the accuracy of measurement for low current signals, will be further influenced. On the other hand, when the power supply is disconnected, due to the effect of the magnetic field, the induced current generated by the closed circuit formed of the manganin current divider, the signal lines, and the circuit board of the electronic electric meter will lead to an indication in the electric meter, and cause the electric meter measuring false electrical consumption without any loadings. In the electric meter with such a structure, the manganin current divider 100 is typically connected at one side of the relay 104. Due to the influence of the interfering magnetic field by the cable, a magnetic field interference signal in a definite direction exists at this side of the relay 104, as shown by the arrows in Fig. 4. Thus, the manganin portion 102 connected to one side of the relay 104 is perpendicular to the field direction, so that the entire surface of the manganin portion 102 is passed through by the magnetic induction line. Therefore, the circuit will be disturbed by the magnetic field heavily. In addition, the electronic electric meter will be disturbed by the magnetic field interference signals in indefinite directions.

SUMMARY OF THE INVENTION

The invention seeks to overcome the defects in prior art, and provide an electronic electric meter resistant to alternating magnetic field interferences, which has an improved structure of a current divider, thus can reduce an alternating magnetic field interferences to the current divider acting as a current sampling element and reduce the influence of the magnetic field to the current sampling signals, so as to effectively ensure the accuracy of measurement by the electronic electric meter.

The technical solution for solving the technical problem of the invention is an electronic electric meter resistant to alternating magnetic field interferences, which comprises a current divider, a relay, and a circuit board of the electronic electric meter. The current divider is connected to a terminal of the relay. The current divider has a shape of a sheet, and contains a sampling resistor sheet made of a high resistivity material. A through hole is provided in the sampling resistor sheet. A first connecting end and a second connecting end are provided at both ends of the sampling resistor sheet, respectively. The first connecting end is formed by protruding upwards integrally from an upper-side edge of the current divider, and the second connecting end is formed by protruding downwards integrally from a lower-side edge of the current divider. The first connecting end is connected to a first signal line and the second connecting end is connected to a second signal line. The second signal line connected to the second connecting end, after passing through the through hole, is twisted together with the first signal line connected to the first connecting end, and the ends of the first and second signal lines are connected to the circuit board of the electronic electric meter, respectively.

The current divider may further comprise a first conducting sheet and a second conducting sheet. The sampling resistor sheet is connected between the first conducting sheet and the second conducting sheet. The current divider is connected to the terminal at one side of the relay via the first conducting sheet.

The first connecting end and the second connecting end are separately provided on the sampling resistor sheet.

The first connecting end may be provided on the first conducting sheet and located close to the sampling resistor sheet, and the second connecting end may be provided on the second conducting sheet and located close to the sampling resistor sheet.

Alternatively, the first connecting end may be provided on the second conducting sheet and located close to the sampling resistor sheet, and the second connecting end may be provided on the first conducting sheet and located close to the sampling resistor sheet.

The two signal lines may be bent into transverse directions and connected correspondingly to the first connecting end and the second connecting end by welding, respectively.

Both ends of the sampling resistor sheet may be integrally connected to the first conducting sheet and the second conducting sheet, respectively.

In the electronic electric meter resistant to alternating magnetic field interferences according to the invention, the first connecting end and the second connecting end for connecting the signal lines for achieving the current sampling are provided on the upper-side and the lower-side of the current divider, respectively, and a through hole is provides in the sampling resistor sheet to allow the signal line connected to the second connection end on the lower-side of the current divider passing therethrough. The first and second connecting ends for connecting the signal lines are on the upper-side and the lower-side, respectively, i.e., the terminals (guiding pins) of the sampling resistor sheet are on the upper-side and the lower-side, respectively, and the signal line connected on the lower-side passes through the through hole of the sampling resistor sheet and is twisted together with the signal line on the upper-side above the sampling resistor sheet. Therefore, on the one hand, the signal line connected on the lower-side may separate the sampling resistor sheet into two areas by passing through the through hole of the sampling resistor sheet. Thus in the magnetic field, the sampling resistor sheet will be separated into two areas in the projective plane (i.e. the plane perpendicular to the field direction) by the signal line, and form two circuits with opposite current directions. Under the effect of a definite alternating magnetic field (from the magnetic field interferences generated by a cable), the induced current generated on both sides will flow in opposite directions, which can be counteracted with each other. On the other hand, the signal line may be used, after passing through the through hole of the sampling resistor sheet, to form two circuits with the sampling resistor sheet. The two circuits have opposite current directions in the lateral projective plane of the sampling resistor sheet. Under the effect of an indefinite alternating magnetic field (the field direction is not perpendicular to the sampling resistor sheet), the induced current generated on both sides will flow in opposite directions, which can be counteracted with each other. Therefore, the interferences can be reduced, i.e., both definite and indefinite alternating magnetic field interferences to the current divider can be resisted.

Some advantageous effects of the invention are as follows: the first and the second connecting ends for connecting the signal lines to achieve the current sampling of the current divider are provided on the upper-side and the lower-side of the current divider, respectively, and a through hole is provided in the sampling resistor sheet to allow the signal line connected on the lower-side to pass therethrough and be twisted together with the signal line on the upper-side above the sampling resistor sheet, thus on the one hand, the sampling resistor sheet is in the magnetic field, and there are two circuits with opposite current directions on two sides of the sampling resistor sheet, so that under the effect of a definite alternating magnetic field (from the magnetic field interferences generated by a cable), the induced current generated by the two sides will flow in opposite directions, which can be counteracted with each other; on the other hand, the signal lines can form two circuits with the sampling resistor sheet, and the two circuits have opposite current directions in the lateral projective plane of the sampling resistor sheet, so that under the effect of an indefinite alternating magnetic field (the field direction is not perpendicular to the sampling resistor sheet), the induced current generated on the two sides flow in opposite directions, which can be counteracted with each other. Therefore, the purpose for resisting a definite or indefinite alternating magnetic field interferences to the current divider can be achieved.

Comparing with the prior art, for example, the invention can bring about the following advantageous effects:

    1. Reducing the magnetic field interferences to the current divider;
    2. Processing easily and enabling batch industrialization;

    3. Low cost.

## BRIEF DESCRIPTION OF THE DRAWINGS

The invention is hereinafter described in more detail by means of the accompanying drawings and embodiments; but the electronic electric meter resistant to alternating magnetic field interferences according to the invention is not limited by the embodiments.

    Fig. 1 is a schematic diagram of a configuration of an electronic electric meter in prior art;
    Fig. 2 is a schematic diagram of a structure of a current sampling circuit of the electronic electric meter in prior art;
    Fig. 3 is a schematic diagram of a structure of a manganin current divider of the electronic electric meter in prior art;
    Fig. 4 is a schematic diagram of an installation of a manganin current divider of the electronic electric meter in prior art;
    Fig. 5 is a schematic diagram of a structure of a current divider of the electronic electric meter according to the invention;
    Fig. 6 is the front view of a current divider of an electronic electric meter according to the invention;
    Fig. 7 is a schematic diagram of a structure of a current divider connecting the signal lines in the electronic electric meter according to the invention;
    Fig. 8 is a schematic diagram of an installation of a current divider of the electronic electric meter according to the invention;
    Fig. 9 is a schematic diagram of a connection between a current divider and signal lines of an electronic electric meter according to the invention;
    Fig. 10 is a schematic diagram from back view of Fig. 9;
    Fig. 11 is the sectional view along the line A-A as shown in Fig. 10.

## DETAILED DESCRIPTION OF THE EMBODIMENTS

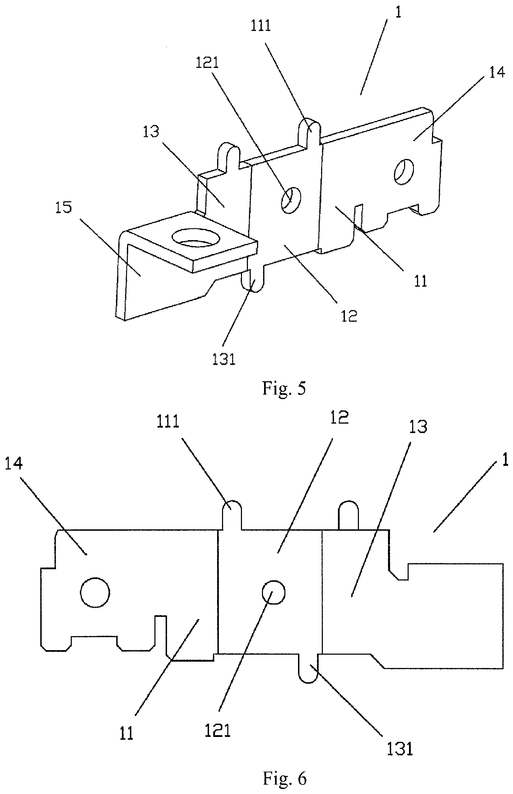

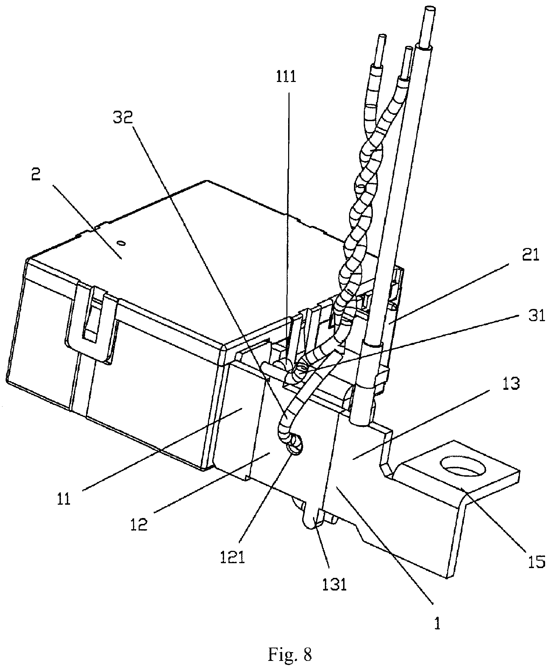

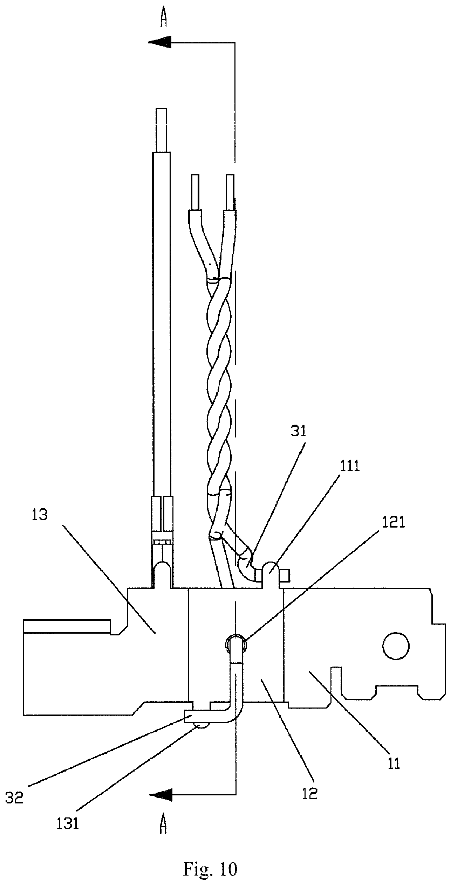

Referring now to Figs. 5-11, an electronic electric meter resistant to alternating magnetic field interferences according to the invention comprises a current divider 1, a relay 2, and a circuit board (not shown) of the electronic electric meter. The current divider 1 comprises a first conducting sheet 11, a sampling resistor sheet 12 and a second conducting sheet 13, wherein the sampling resistor sheet is made of a high resistivity material, which is manganin in this embodiment. Of course, the high resistivity material can also be other types of the materials, such as constantan. The first conducting sheet 11 and the second conducting sheet 13 are made of copper, which of course can also be other conducting materials. Each of the ends of the sampling resistor sheet 12 is integrally connected to the first conducting sheet 11 and the second conducting sheet 13, respectively. The current divider 1 is connected to a terminal on one side 21 of the relay 2 via the first conducting sheet 11. Actually, a first fixing end 14 connected to the relay is also provided on the current divider 1, to achieve a connection to the terminal of the relay 2, wherein the first fixing end 14 is integrally connected to the first conducting sheet 11. A second fixing end 15 connected to the electric meter is also provided on the current divider 1. The second fixing end 15 is integrally connected to the second conducting sheet 13. An interfering magnetic field in a definite direction exists at the installation position of the current divider, and the direction is perpendicular to the current divider, when the connections as shown in Fig. 8 are used. The sampling resistor sheet 12 has a planar structure, and the first conducting sheet 11 and the second conducting sheet 13 have also planar structures. A through hole 121 is provided in the sampling resistor sheet 12. A first connecting end 111 and a second connecting end 131 are provided at both ends of the sampling resistor sheet 12, respectively, wherein the first connecting end 111 is formed by protruding upwards integrally from an upper-side edge of the current divider, and the second connecting end 131 is formed by protruding downwards integrally from a lower-side edge of the current divider. A first signal line 31 is connected to the first connecting end 111, and a second signal line 32 is connected to the second connecting end 131, wherein the second signal line 32 on the second connecting end 131, after passing through the through hole 121, is twisted together with the first signal line 31 on the first connecting end 111 on the upper-side. The ends of the two signal lines 31, 32 are respectively connected to the circuit board of the electronic electric meter.

In an embodiment, the first connecting end 111 and the second connecting end 131 are respectively provided on the sampling resistor sheet, wherein the first connecting end 111 is provided on the upper-side of the sampling resistor sheet, and the second connecting end 131 is provided on the lower-side of the sampling resistor sheet.

Of course, the first connecting end and the second connecting end can be arranged in two other solutions: the first connecting end is provided on the first conducting sheet and located close to the sampling resistor sheet, and the second connecting end is provided on the second conducting sheet and located close to the sampling resistor sheet; or the first connecting end is provided on the second conducting sheet and located close to the sampling resistor sheet, and the second connecting end is provided on the first conducting sheet and located close to the sampling resistor sheet.

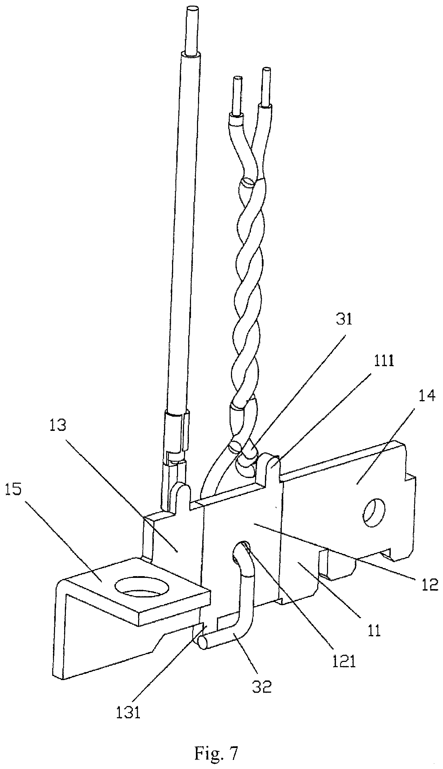

The first and second signal lines 31, 32 are bent into transverse directions and connected to the corresponding first connecting end 111 and the second connecting end 131 by welding, respectively (as shown in Figs. 7, 8). That is, the two wires (signal lines) are bent into transverse directions (namely horizontal direction) and fixed to the first and second connecting ends by welding, respectively, so as to further reduce the area surrounded by the two signal lines and the sampling resistor sheet.

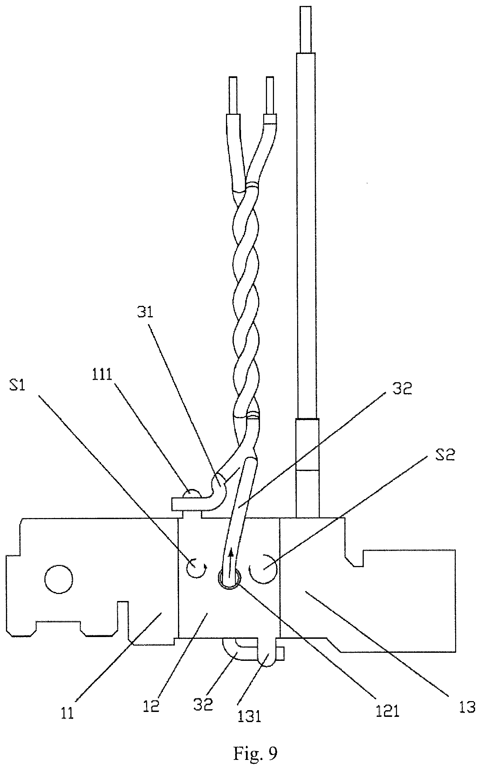

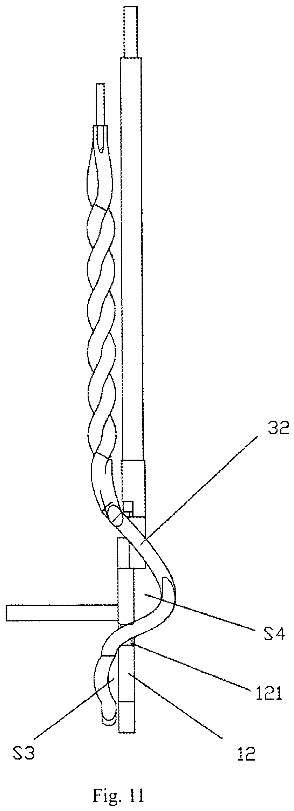

In the electronic electric meter resistant to alternating magnetic field interferences according to the invention, the first connecting end 111 and the second connecting end 131 for connecting the first and second signal lines, so as to achieve the current sampling are provided on the upper-side and the lower-side of the current divider, respectively, and a through hole 121 is provided in the sampling resistor sheet 12, so as to allow the signal line connected to the second connection end 131 on the lower-side of the current divider passing through the through hole 121. The first connecting end 111 and the second connecting end 131 connecting the signal lines are on the upper-side and the lower-side, respectively, i.e. the terminals of the sampling resistor sheet are on the upper-side and the lower-side respectively, and the second signal line 32 connected on the lower-side passes through the through hole 121 of the sampling resistor sheet and is twisted together with the first signal line 31 on the upper-side above the sampling resistor sheet. Therefore, on the one hand, the second signal line 32 connected on the lower-side will separate the sampling resistor sheet into two areas by passing through the through hole 121 of the sampling resistor sheet. Thus in the magnetic field, the sampling resistor sheet will be separated into two areas in the projective plane (i.e. the plane perpendicular to the field direction) by the signal line, and forms two circuits with opposite current directions, as the circuits S1 and S2 shown in Fig. 9. Under the effect of a definite alternating magnetic field (from the magnetic field interferences generated by a cable), the induced currents generated on both sides will flow in opposite directions, which can be counteracted with each other. On the other hand, the second signal line 32 may be used, after passing through the through hole 121 of the sampling resistor sheet, to form two circuits together with the sampling resistor sheet. The two circuits have opposite current directions in the lateral projective plane of the sampling resistor sheet, as the circuits S3 and S4 shown in Fig. 11. Under the effect of an indefinite alternating magnetic field (the field direction is not perpendicular to the sampling resistor sheet), the induced current generated on both sides of the sampling resistor sheet flow in opposite directions, which can be counteracted with each other. Therefore, the interferences can be reduced, i.e. definite or indefinite alternating magnetic field interferences to the current divider can be resisted.

The above embodiments are only used to specifically describe an electronic electric meter resistant to alternating magnetic field interferences according to the invention, but the invention is not limited by the embodiments, its scope being defined by the appended claims.

**Practical Applicability**

The invention relates to an electronic electric meter resistant to alternating magnetic field interferences, which can both counteract alternating magnetic field interferences in a definite direction (interferences generated by a cable), and counteract alternating magnetic field interferences in an indefinite direction in operation, so as to effectively ensure the accuracy of measurement by the electronic electric meter.

**Claims**

1. An electronic electric meter resistant to alternating magnetic field interferences, comprising a current divider (1), a relay (2), and a circuit board of the electronic electric meter; the current divider (1) being connected to a terminal of the relay (2); the current divider (1) having a shape of a sheet, and comprising a sampling resistor sheet (12) made of a high resistivity material; **characterized in that** a through hole (121) is provided in the sampling resistor sheet (12); a first connecting end (111) and a second connecting end (131) are provided at both ends of the sampling resistor sheet (12), wherein the first connecting end (111) is formed by protruding upwards integrally from an upper-side edge of the current divider (1), and the second connecting end (131) is formed by protruding downwards integrally from a lower-side edge of the current divider (1); the first connecting end (111) is connected to a first signal line (31) and the second connecting end (131) is connected to a second signal line (32), and the second signal line (32) connected to the second connecting end (131), after passing through the through hole (121), is twisted together with the first signal line (31) connected to the first connecting end (111); the ends of the first and second signal lines (31, 32) are connected to the circuit board of the electronic electric meter, respectively.

2. The electronic electric meter resistant to alternating magnetic field interferences according to claim 1, **characterized in that** the current divider (1) further comprises a first conducting sheet (11) and a second conducting sheet (13) with the sampling resistor sheet (12) connected therebetween, wherein the current divider (1) is connected to the terminal of one side (21) of the relay (2) via the first conducting sheet (11).

3. The electronic electric meter resistant to alternating magnetic field interferences according to claim 2, **characterized in that** the first connecting end (111) and the second connecting end (131) are separately provided on the sampling resistor sheet (12).

4. The electronic electric meter resistant to alternating magnetic field interferences according to claim 2, **characterized in that** the first connecting end (111) is provided on the first conducting sheet (11), and located close to the sampling resistor sheet (12); the second connecting end (131) is provided on the second conducting sheet (13), and located close to the sampling resistor sheet (12).

5. The electronic electric meter resistant to alternating magnetic field interferences according to claim 2, **characterized in that** the first connecting end (111) is provided on the second conducting sheet (13), and located close to the sampling resistor sheet (12); the second connecting end (131) is provided on the first conducting sheet (11), and located close to the sampling resistor sheet (12).

6. The electronic electric meter resistant to alternating magnetic field interferences according to any one of claims 1-5, **characterized in that** the two signal lines (31, 32) are bent into transverse direction and connected correspondingly to the first connecting end (111) and the second connecting end (131) by welding, respectively.

7. The electronic electric meter resistant to alternating magnetic field interferences according to claim 2, **characterized in that** both ends of the sampling resistor sheet (12) are integrally connected to the first conducting sheet (11) and the second conducting sheet (13), respectively.

8. The electronic electric meter resistant to alternating magnetic field interferences according to claim 2, **characterized in that** among the signal lines (31, 32) respectively connected to the first connecting end (111) on the upper-side of the sampling resistor sheet (12) and the second connecting end (131) on the lower-side of the sampling resistor sheet (12), the signal line connected on the lower-side separates the sampling resistor sheet (12) into two areas by passing through the through hole (121) of the sampling resistor sheet (12), so that in the magnetic field, the sampling resistor sheet (12) is separated into two areas in the projective plane by the signal line connected on the lower-side, and forms two circuits with opposite current directions, wherein under an effect of a definite alternating magnetic field, induced currents generated on both sides flow in opposite directions and can be counteracted with each other.

9. The electronic electric meter resistant to alternating magnetic field interferences according to claim 2, **characterized in that** among the signal lines (31, 32) respectively connected to the first connecting end (111) on the upper-side of the sampling resistor sheet (12) and the second connecting end (131) on the lower-side of the sampling resistor sheet (12), the signal line connected on the lower-side, after passing through the through hole (121) of the sampling resistor sheet (12), forms two circuits together with the sampling resistor sheet (12), wherein the two circuits have opposite current directions in the lateral projective plane of sampling resistor sheet (12), wherein under an effect of an indefinite alternating magnetic field, the induced currents generated on both sides flow in opposite directions, which can be counteracted with each other.

**Patentansprüche**

1. Elektronischer Elektrizitätszähler, der gegen Interferenzen eines magnetischen Wechselfelds resistent ist, umfassend einen Stromteiler (1), ein Relais (2), und eine Leiterplatte des elektronischen Elektrizitätszählers;
   wobei der Stromteiler (1) mit einem Anschluss des Relais (2) verbunden ist;
   wobei der Stromteiler (1) eine Form einer Platte aufweist und eine Abtastwiderstandsplatte (12) umfasst, die aus einem hochohmigen Material hergestellt ist;
   **dadurch gekennzeichnet, dass** ein Durchgangsloch (121) in der Abtastwiderstandsplatte (12) bereitgestellt ist;
   ein erstes Verbindungsende (111) und ein zweites Verbindungsende (131) an beiden Enden der Abtastwiderstandsplatte (12) bereitgestellt sind, wobei das erste Verbindungsende (111) durch einstückiges nach oben gerichtetes Vorstehen von einer oberseitigen Kante des Stromteilers (1) ausgebildet ist und das zweite Verbindungsende (131) durch einstückiges nach unten gerichtetes Vorstehen von einer unterseitigen Kante des Stromteilers (1) ausgebildet ist;
   das erste Verbindungsende (111) mit einer ersten Signalleitung (31) verbunden ist und das zweite Verbindungsende (131) mit einer zweiten Signalleitung (32) verbunden ist, und die zweite Signalleitung (32), die mit dem zweiten Verbindungsende (131) verbunden ist, nach dem Durchführen durch das Durchgangsloch (121) zusammen mit der ersten Signalleitung (31), die mit dem ersten Verbindungsende (111) verbunden ist, verdreht ist;
   die Enden der ersten und zweiten Signalleitung (31, 32) jeweils mit der Leiterplatte des elektronischen Elektrizitätszählers verbunden sind.

2. Elektronischer Elektrizitätszähler, der gegen Interferenzen eines magnetischen Wechselfelds resistent ist, nach Anspruch 1, **dadurch gekennzeichnet, dass** der Stromteiler (1) ferner eine erste leitende Platte (11) und eine zweite leitende Platte (13) umfasst, wobei die Abtastwiderstandsplatte (12) dazwischen verbunden ist, wobei der Stromteiler (1) über die erste leitende Platte (11) mit dem Anschluss an einer Seite (21) des Relais (2) verbunden ist.

3. Elektronischer Elektrizitätszähler, der gegen Interferenzen eines magnetischen Wechselfelds resistent ist, nach Anspruch 2, **dadurch gekennzeichnet, dass** das erste Verbindungsende (111) und das zweite Verbindungsende (131) getrennt an der Abtastwiderstandsplatte (12) bereitgestellt sind.

4. Elektronischer Elektrizitätszähler, der gegen Interferenzen eines magnetischen Wechselfelds resistent ist, nach Anspruch 2, **dadurch gekennzeichnet, dass** das erste Verbindungsende (111) an der ersten leitenden Platte (11) bereitgestellt ist und nahe der Abtastwiderstandsplatte (12) gelegen ist;
   das zweite Verbindungsende (131) an der zweiten leitenden Platte (13) bereitgestellt ist und nahe der Abtastwiderstandsplatte (12) gelegen ist.

5. Elektronischer Elektrizitätszähler, der gegen Interferenzen eines magnetischen Wechselfelds resistent ist, nach Anspruch 2, **dadurch gekennzeichnet, dass** das erste Verbindungsende (111) an der zweiten leitenden Platte (13) bereitgestellt ist und nahe der Abtastwiderstandsplatte (12) gelegen ist;
   das zweite Verbindungsende (131) an der ersten leitenden Platte (11) bereitgestellt ist und nahe der Abtastwiderstandsplatte (12) gelegen ist.

6. Elektronischer Elektrizitätszähler, der gegen Interferenzen eines magnetischen Wechselfelds resistent ist, nach einem der Ansprüche 1-5, **dadurch gekennzeichnet, dass** die zwei Signalleitungen (31, 32) in eine Querrichtung gebogen sind und entsprechend jeweils mit dem ersten Verbindungsende (111) und dem zweiten Verbindungsende (131) durch Schweißen verbunden sind.

7. Elektronischer Elektrizitätszähler, der gegen Interferenzen eines magnetischen Wechselfelds resistent ist, nach Anspruch 2, **dadurch gekennzeichnet, dass** beide Enden der Abtastwiderstandsplatte (12) einstückig mit jeweils der ersten leitenden Platte (11) und der zweiten leitenden Platte (13) verbunden sind.

8. Elektronischer Elektrizitätszähler, der gegen Interferenzen eines magnetischen Wechselfelds resistent ist, nach Anspruch 2, **dadurch gekennzeichnet, dass** unter den Signalleitungen (31, 32), die jeweils mit dem ersten Verbindungsende (111) an der Oberseite der Abtastwiderstandsplatte (12) und dem zweiten Verbindungsende (131) an der Unterseite der Abtastwiderstandsplatte (12) verbunden sind, die an der Unterseite verbundene Signalleitung die Abtastwiderstandsplatte (12) durch Durchführen durch das Durchgangsloch (121) der Abtastwiderstandsplatte (12) in zwei Bereiche trennt, sodass in dem Magnetfeld die Abtastwiderstandsplatte (12) durch die an der Unterseite verbundene Signalleitung in zwei Bereiche in der projektiven Ebene getrennt ist und zwei Schaltkreise mit entgegengesetzten Stromrichtungen ausbildet, wobei unter einer Wirkung eines bestimmten magnetischen Wechselfelds beidseitig erzeugte induzierte Ströme in entgegengesetzte Richtungen fließen und sich gegenseitig entgegenwirken lassen.

9. Elektronischer Elektrizitätszähler, der gegen Interferenzen eines magnetischen Wechselfelds resistent ist, nach Anspruch 2, **dadurch gekennzeichnet, dass** unter den Signalleitungen (31, 32), die jeweils mit dem ersten Verbindungsende (111) an der Oberseite der Abtastwiderstandsplatte (12) und dem zweiten Verbindungsende (131) an der Unterseite der Abtastwiderstandsplatte (12) verbunden sind, die an der Unterseite verbundene Signalleitung nach dem Durchführen durch das Durchgangsloch (121) der Abtastwiderstandsplatte (12) zwei Schaltkreise zusammen mit der Abtastwiderstandsplatte (12) ausbildet, wobei die zwei Schaltkreise entgegengesetzte Stromrichtungen in der seitlichen projektiven Ebene der Abtastwiderstandsplatte (12) aufweisen, wobei unter einer Wirkung eines unbestimmten magnetischen Wechselfelds die beidseitig erzeugten induzierten Ströme in entgegengesetzte Richtungen fließen, die sich gegenseitig entgegenwirken lassen.

**Revendications**

1. Compteur électrique électronique résistant aux interférences de champ magnétique alternatif, comprenant un diviseur de courant (1), un relais (2) et une carte de circuit imprimé du compteur électrique électronique ; le diviseur de courant (1) étant connecté à une borne du relais (2) ; le diviseur de courant (1) ayant la forme d'une feuille et comprenant une feuille de résistance d'échantillonnage (12) constituée d'un matériau à haute résistivité ; **caractérisé en ce qu'**un trou traversant (121) est fourni dans la feuille de résistance d'échantillonnage (12) ; une première extrémité de connexion (111) et une seconde extrémité de connexion (131) sont fournies aux deux extrémités de la feuille de résistance d'échantillonnage (12), la première extrémité de connexion (111) étant formée en faisant saillie vers le haut intégralement à partir d'un bord latéral supérieur du diviseur de courant (1) et la seconde extrémité de connexion (131) étant formée en faisant saillie vers le bas intégralement à partir d'un bord latéral inférieur du diviseur de courant (1) ; la première extrémité de connexion (111) est connectée à une première ligne de signal (31) et la seconde extrémité de connexion (131) est connectée à une seconde ligne de signal (32), et la seconde ligne de signal (32) connectée à la seconde extrémité de connexion (131), après avoir traversé le trou traversant (121), est torsadée avec la première ligne de signal (31) connectée à la première extrémité de connexion (111) ; les extrémités des première et seconde lignes de signal (31, 32) sont connectées à la carte de circuit imprimé du compteur électrique électronique, respectivement.

2. Compteur électrique électronique résistant aux interférences de champ magnétique alternatif selon la revendication 1, **caractérisé en ce que** le diviseur de courant (1) comprend en outre une première feuille conductrice (11) et une seconde feuille conductrice (13) avec la feuille de résistance d'échantillonnage (12) connectées entre elles, dans lequel le diviseur de courant (1) est connecté à la borne d'un côté (21) du relais (2) par l'intermédiaire de la première feuille conductrice (11).

3. Compteur électrique électronique résistant aux interférences de champ magnétique alternatif selon la revendication 2, **caractérisé en ce que** la première extrémité de connexion (111) et la seconde extrémité de connexion (131) sont fournies séparément sur la feuille de résistance d'échantillonnage (12).

4. Compteur électrique électronique résistant aux interférences de champ magnétique alternatif selon la revendication 2, **caractérisé en ce que** la première extrémité de connexion (111) est fournie sur la première feuille conductrice (11) et est située à proximité de la feuille de résistance d'échantillonnage (12) ; la seconde extrémité de connexion (131) est fournie sur la seconde feuille conductrice (13) et est située à proximité de la feuille de résistance d'échantillonnage (12).

5. Compteur électrique électronique résistant aux interférences de champ magnétique alternatif selon la revendication 2, **caractérisé en ce que** la première extrémité de connexion (111) est fournie sur la seconde feuille conductrice (13) et est située à proximité de la feuille de résistance d'échantillonnage (12) ; la seconde extrémité de connexion (131) est fournie sur la première feuille conductrice (11) et située à proximité de la feuille de résistance d'échantillonnage (12).

6. Compteur électrique électronique résistant aux interférences de champ magnétique alternatif selon l'une quelconque des revendications 1 à 5, **caractérisé en ce que** les deux lignes de signal (31, 32) sont courbées dans une direction transversale et connectées de manière correspondante à la première extrémité de connexion (111) et la seconde extrémité de connexion (131) par soudage, respectivement.

7. Compteur électrique électronique résistant aux interférences de champ magnétique alternatif selon la revendication 2, **caractérisé en ce que** les deux extrémités de la feuille de résistance d'échantillonnage (12) sont intégralement connectées à la première feuille conductrice (11) et à la seconde feuille conductrice (13), respectivement.

8. Compteur électrique électronique résistant aux interférences de champ magnétique alternatif selon la revendication 2, **caractérisé en ce que**, parmi les lignes de signal (31, 32) connectées respectivement à la première extrémité de connexion (111) sur le côté supérieur de la feuille de résistance d'échantillonnage (12) et la seconde extrémité de connexion (131) sur le côté inférieur de la feuille de résistance d'échantillonnage (12), la ligne de signal connectée sur le côté inférieur sépare la feuille de résistance d'échantillonnage (12) en deux zones en traversant le trou traversant (121) de la feuille de résistance d'échantillonnage (12), de sorte que dans le champ magnétique, la feuille de résistance d'échantillonnage (12) est séparée en deux zones dans le plan projectif par la ligne de signal connectée au côté inférieur, et forme deux circuits avec des directions de courant opposées, dans lequel, sous l'effet d'un champ magnétique alternatif défini, les courants induits générés des deux côtés circulent dans des directions opposées et peuvent se neutraliser entre eux.

9. Compteur électrique électronique résistant aux interférences de champ magnétique alternatif selon la revendication 2, **caractérisé en ce que**, parmi les lignes de signal (31, 32) connectées respectivement à la première extrémité de connexion (111) sur le côté supérieur de la feuille de résistance d'échantillonnage (12) et la seconde extrémité de connexion (131) sur le côté inférieur de la feuille de résistance d'échantillonnage (12), la ligne de signal étant connectée sur le côté inférieur, après avoir traversé le trou traversant (121) de la feuille de résistance d'échantillonnage (12), forme deux circuits conjointement avec la feuille de résistance d'échantillonnage (12), les deux circuits ayant des directions de courant opposées dans le plan projectif latéral de la feuille de résistance d'échantillonnage (12), sous l'effet d'un champ magnétique alternatif indéfini, les courants générés des deux côtés circulant dans des directions opposées, ce qui peut être neutralisé entre eux.

Fig. 1

Fig. 2

Fig. 3

104

1011

1031

100

101

103

B

102

Fig. 4

Fig. 5

Fig. 6

Fig. 7

Fig. 8

Fig. 9

Fig. 10

Fig. 11

**EP 2 924 448 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4494068 A
- CN 201429643 Y
- CN 202177647 U